# FASCICULE DE BREVET EUROPEEN

(11) **EP 3 253 903 B1**
(45) Date de publication et mention de la délivrance du brevet: **05.12.2018**
(21) Numéro de dépôt: 15823620.8
(22) Date de dépôt: 08.12.2015
(51) Int. Cl.: C23C 16/32, C23C 16/513, B32B 38/00

(54) **PROCÉDÉ D'ENCAPSULATION DE VITRAGES EN POLYCARBONATE POURVUS D'UN REVÊTEMENT ANTI-RAYURES**
VERFAHREN ZUM VERKAPSELUNG VON VERGLASUNG IN POLYCARBONAT MIT EINER KRATZSCHUTZBESCHICHTUNG
METHOD FOR ENCAPSULATING GLAZING IN POLYCARBONATE PROVIDED WITH AN ANTI-SCRATCH COATING

(30) Priorité: 05.02.2015 FR 1550922
(43) Date de publication de la demande: 13.12.2017
(73) Titulaire: Saint-Gobain Glass France, 92400 Courbevoie (FR)
(72) Inventeur: THIMONIER, Sylvain, 60190 Estrees Saint Denis (FR)
(74) Mandataire: Saint-Gobain Recherche
(86) Numéro de dépôt international: PCT/FR2015/053383
(87) Numéro de publication internationale: WO 2016/124824

(56) Documents cités:
- EP-A2- 0 285 870
- EP-B1- 2 144 958
- SCHMAUDER T ET AL: "Hard coatings by plasma CVD on polycarbonate for automotive and optical applications", THIN SOLID FILMS, ELSEVIER-SEQUOIA S.A. LAUSANNE, CH, vol. 502, no. 1-2, 28 avril 2006 (2006-04-28), pages 270-274, XP025006253, ISSN: 0040-6090, DOI: 10.1016/J.TSF.2005.07.296 [extrait le 2006-04-28]

## Description

La présente invention concerne un nouveau procédé d'encapsulation de vitrages automobiles en polycarbonate qui comprend une étape de prétraitement par plasma atmosphérique.

Dans le domaine industriel des vitrages automobiles, le terme « encapsulation » désigne un procédé ou une étape de surmoulage d'une matière polymérique autour du périmètre d'un vitrage. La matière est injectée à l'état fluide dans un moule formant un cadre étanche autour du bord du vitrage. Après durcissement de la matière par réaction de polymérisation et/ou de réticulation (cas des polymères thermodurcissables) ou par refroidissement (cas des polymères thermoplastiques), le moule est ouvert et retiré, laissant en périphérie du vitrage un cordon profilé en contact avec la tranche et au moins une des deux faces du vitrage, souvent avec les deux faces du vitrage.

Le polymère formant le cordon profilé est souvent un élastomère capable de jouer le rôle de joint entre le vitrage et la carrosserie. Des polymères qui ne sont pas des élastomères peuvent toutefois également être surmoulés par encapsulation pour jouer d'autres fonctions. Le cordon profilé obtenu est alors généralement un cordon composite comprenant à la fois des éléments élastomères et des éléments non élastomères juxtaposés.

L'étape d'encapsulation est généralement précédée d'une étape de nettoyage et d'activation de la surface à surmouler, en périphérie du vitrage, puis un primaire est appliqué sur la zone activée destinée à venir en contact avec le cordon profilé surmoulé.

Dans le domaine des vitrages automobiles en verre minéral, il est connu d'utiliser l'activation par plasma à pression atmosphérique, également appelé plasma froid. L'oxydation de la surface aboutit à la formation de groupes réactifs, majoritairement des groupes SiOH, capables de réagir avec le primaire.

Dans le domaine des vitrages automobiles en polycarbonate cette technique d'activation par plasma, avant primage et encapsulation, n'a jusqu'ici pas permis d'obtenir des résultats satisfaisants.

Le polycarbonate est un matériau utilisé en remplacement du verre silicaté pour certains vitrages tels que les toits vitrés, les vitres latérales fixes et les lunettes arrière, ainsi que pour les verres diffuseurs des phares. Malgré de nombreux avantages (faible poids, résistance au choc, facilité de formage) le polycarbonate souffre, en tant que matériau de remplacement du verre automobile, d'une grande sensibilité aux éraflures.

Tous les vitrages automobiles en polycarbonates doivent de ce fait être revêtus d'un revêtement transparent dur (*hardcoat*) anti-éraflures (*anti-scratching*) et anti-rayures (*anti-scoring*) pour garantir une transparence suffisante au vitrage tout au long de la vie du véhicule.

Ces revêtements sont des nanocomposites à base de silicone (polyorganosiloxanes) et de nanoparticules à dureté élevée, généralement des particules de silice. Il s'agit de revêtements hydrophobes ayant une énergie de surface inférieure à 30 mN/m et une épaisseur de l'ordre de quelques centaines de nanomètres (100 - 1000 nm).

Lorsqu'on souhaite encapsuler les vitrages en polycarbonate protégés par de tels revêtements anti-abrasion/anti-rayures, désignés couramment par le terme anglais *hardcoat*, on se trouve confronté au difficile problème de l'activation de cette surface très dure, chimiquement inerte et difficile à mouiller. Le traitement connu par plasma atmosphérique utilisé avec succès pour le verre minéral ne permet pas l'activation des surfaces des *hardcoats* recouvrant les vitrages en polycarbonate.

On ne connaît pas non plus de traitement chimique satisfaisant permettant d'améliorer la mouillabilité de la surface des *hardcoats* siliconés, d'augmenter leur rugosité et d'y introduire des fonctions chimiques susceptibles de réagir avec les composants du primaire (isocyanates).

Jusqu'ici la seule technique satisfaisante permettant d'obtenir une bonne adhésion des compositions de primage et des matières d'encapsulation injectées est l'enlèvement du *hardcoat* par abrasion mécanique des surfaces à encapsuler. Cette technique pose toutefois un certain nombre de problèmes :
- les fines poussières de matières plastiques peuvent être inhalées par les opérateurs à proximité ;
- l'abrasion mécanique allonge le temps de cycle et impose de fortes contraintes d'aménagement de la zone de fabrication (enceinte fermée, système d'aspiration) ;
- les poussières générées par l'abrasion mécanique peuvent se déposer sur les vitrages plastiques et créer des défauts rédhibitoires après encapsulation ;
- de nombreuses opérations de nettoyage préventif sont nécessaires.

Dans le cadre de ses recherches visant à remplacer l'abrasion mécanique des *hardcoats* sur polycarbonates, la Demanderesse a constaté avec surprise qu'une technique connue, jugée jusqu'ici inefficace, permettait d'atteindre cet objectif à condition de l'utiliser dans des conditions inhabituelles.

La technique du plasma atmosphérique est en effet utilisée industriellement avec des distances buse/substrat à activer comprise entre environ 1 et 5 cm en fonction du matériau à traiter, de la puissance du plasma, de la dimension de la buse et de la vitesse de défilement. C'est en effectuant des essais d'activation par plasma froid avec des distances buse/substrat beaucoup plus réduites que l'inventeur s'est rendu compte que cette technique connue permettait, contrairement à ce qu'on avait observé jusqu'ici, d'augmenter l'énergie de surface et la rugosité des zones traitées et d'y introduire, notamment par oxydation, des fonctions chimiques susceptibles de réagir avec les compositions de primage.

Contrairement à ce qu'on avait craint, cette abrasion par plasma froid « rapproché » n'entraîne aucune dégradation thermique des vitrages traités. Elle permet en outre de raccourcir le temps de cycle et de réduire considérablement les coûts liés à l'encapsulation. L'absence de formation de poussières constitue un avantage considérable du point de vue de l'environnement et de la santé des opérateurs.

Pour obtenir des résultats d'adhésion satisfaisants entre un vitrage en polycarbonate et un cordon de surmoulage en polymère thermoplastique (dont le durcissement dans le moule d'encapsulation n'implique pas de réaction chimique) il a été en outre nécessaire d'effectuer un primage de la zone traitée par plasma. Certains agents de primage se sont avérés particulièrement satisfaisants de ce point de vue.

La présente invention a pour objet un procédé d'encapsulation d'un vitrage en polycarbonate comportant sur au moins une de ses faces un revêtement dur anti-abrasion à base de silicone, ledit procédé comprenant les étapes successives suivantes :
(a) le traitement d'une zone de la face du vitrage portant le revêtement dur à base de silicone par plasma atmosphérique avec une buse à plasma d'une puissance comprise de préférence entre 100 voltampères et 1000 voltampères, la distance entre l'extrémité de la buse à plasma et la surface du vitrage étant au plus égale à 7 mm,
(b) l'application, sur ladite zone traitée par plasma atmosphérique, d'une composition de primaire comprenant un ou plusieurs promoteurs d'adhésion choisis parmi les diisocyanates, polyisocyanates et polyoléfines chlorées, en solution ou suspension dans un solvant organique ou aqueux,
(c) l'évaporation du solvant de manière à former une couche de primaire sèche, et
(d) le surmoulage d'un polymère thermoplastique sur la zone couverte par la couche de primaire sèche.

Dans la présente demande les termes buse à plasma et torche à plasma sont utilisés indifféremment pour désigner une source de plasma générant une post-décharge hors équilibre thermique.

On entend par « distance entre l'extrémité de la buse de plasma et la surface du vitrage » la distance la plus courte entre l'orifice de sortie du jet de plasma et la surface du *hardcoat* à traiter.

La buse de plasma a de préférence une puissance comprise entre 200 et 900 voltampères, en particulier entre 300 et 800 voltampères, et idéalement entre 400 et 700 voltampères.

La buse de plasma peut être une buse rotative où l'orifice de sortie du jet de plasma tourne à grande vitesse autour de l'axe central de la buse. Dans une telle buse rotative l'axe du jet de plasma peut être à la normale de la surface à traiter, mais il peut également être incliné par rapport à cette normale. L'angle du cône formé par un jet incliné d'une buse rotative est généralement compris entre 10 et 30°, en particulier entre 12 et 20°. L'axe du jet de plasma est de préférence incliné vers l'extérieur, ce qui a pour conséquence d'élargir la zone traitée.

De telles buses à plasma rotatives sont commercialisées par exemple sous la dénomination Openair® par la société Plasmatreat.

Les buses rotatives présentent l'avantage de permettre le traitement de zones relativement larges en bordure du vitrage. La largeur de la bande qui peut être traitée en un seul passage de la buse est à peu près égale au diamètre du cercle de rotation de l'orifice de la buse.

On utilisera de préférence des buses rotatives permettant de traiter, en un seul passage, une bande d'une largeur comprise entre 1 et 5 cm, de préférence entre 1,5 et 4 cm et de manière particulièrement préférée entre 2 et 3 cm.

La distance entre l'extrémité de la buse de plasma et la surface du vitrage est de préférence inférieure à 6 mm, en particulier au plus égale à 5 mm, et idéalement comprise entre 2 mm et 4 mm.

A l'étape (a) du procédé selon l'invention, la torche à plasma est en déplacement par rapport au vitrage à traiter. Ce déplacement peut être créé grâce à une torche mobile et un substrat fixe ou bien grâce à une torche fixe et un substrat mobile qui défile devant cette torche fixe, ce dernier mode de réalisation étant préféré.

La vitesse de déplacement relatif de la buse à plasma par rapport au vitrage est de préférence comprise entre 1 et 5 m/minute, en particulier entre 2 et 4 m/minute. A l'intérieur de ces fourchettes, on utilisera généralement une vitesse de déplacement relatif d'autant plus grande que la distance entre l'extrémité de la buse et le substrat à traiter est faible.

La buse de plasma fonctionne typiquement avec une pression de gaz porteur comprise entre 3 et 4 bars. Le gaz porteur est de préférence de l'air filtré.

Le procédé de la présente invention englobe en principe des modes de réalisation où la torche à plasma passe plusieurs fois sur une même zone du substrat à traiter. Lorsque c'est le cas, la distance buse-substrat et la vitesse de déplacement peuvent être identiques pour tous les passages. L'une et/ou l'autre peuvent toutefois être différentes d'un passage à l'autre. Lorsque l'étape (a) du procédé comprend plusieurs passages de la torche sur une même zone du substrat, il est essentiel qu'au moins un passage se fasse dans les conditions définies dans la revendication indépendante. Le ou les autres passages pourraient se faire dans d'autres conditions, notamment à une distance buse-substrat plus importante.

De préférence, l'étape (a) ne comprend qu'un seul passage de la buse à plasma sur chaque point du vitrage à traiter.

Le traitement par plasma froid (étape (a)) augmente l'énergie de surface, et donc la mouillabilité du revêtement dur à base de silicone. Avant traitement, cette énergie de surface est inférieure à 30 mN.m⁻¹.

Après l'étape de traitement plasma selon l'invention, elle est au moins égale à 45 mN.m⁻¹, de préférence supérieure à 50 mN.m⁻¹ et idéalement supérieure à 60 mN.m⁻¹.

Dans une deuxième étape du procédé selon l'invention, on applique sur la zone traitée par plasma une composition de primaire.

Cette composition est une composition liquide contenant un ou plusieurs promoteurs d'adhésion en solution ou suspension dans un solvant organique ou aqueux.

L'application peut se faire selon des techniques d'application connues, par exemple au moyen d'un feutre ou d'une mousse imprégnés par la composition de primaire, ou encore par application d'un spray au moyen d'un pulvérisateur.

L'épaisseur du film de primaire, avant séchage, est de préférence inférieure à 300 µm, en particulier comprise entre 20 µm et 200 µm.

Le séchage peut se faire à température ambiante ou sous un léger chauffage, il se fait de préférence à température ambiante.

Après l'étape de séchage, la couche de primaire sèche formée sur la zone traitée par plasma a généralement une épaisseur inférieure à 30 µm, en particulier comprise entre 2 et 20 µm.

Le ou les promoteurs d'adhésion sont choisis dans le groupe constitué des diisocyanates, polyisocyanates et polyoléfines chlorées. Les diisocyanates ou polyisocyanates aliphatiques permettent un primage particulièrement efficace.

La teneur totale en diisocyanates et polyisocyanates de la composition de primaire est généralement comprise entre 20 et 40 % en poids, de préférence entre 25 et 38 % en poids et en particulier entre 30 et 35 % en poids.

La teneur en polyoléfines chlorées de la composition de primaire est généralement comprise entre 5 et 25 % en poids, de préférence entre 7 et 20 % en poids et en particulier entre 10 et 15 % en poids.

Dans un mode de réalisation particulièrement avantageux, les promoteurs d'adhésion sont choisis dans le groupe constitué de l'isophorone-diisocyanate (IPDI), du 4,4'-diphénylméthane-diisocyanate (MDI) et de polyoléfine chlorée greffée d'anhydride maléique.

Les polyoléfines chlorées ont de préférence une teneur en chlore comprise entre 5 et 20 % en poids, de préférence entre 10 et 15 % en poids, et leur masse moyenne en poids est de préférence comprise entre 50 000 et 200 000, de préférence entre 80 000 et 120 000.

Ces polyoléfines sont disponibles sur le marché et sont commercialisées par exemple sous les références Eastman Chlorinated Polyolefin (Eastman), Superchlon (Nippon Paper) et Hardlen (Toyobo).

Après évaporation de la phase solvant, le bord du vitrage, avec la ou les zones traitées par plasma et couverte(s) de la couche de primaire sèche, est entouré d'un moule et un polymère thermoplastique est injecté à l'état fondu.

Le polymère thermoplastique est choisi par exemple parmi les élastomères thermoplastiques styréniques (TPE-S), les élastomères thermoplastiques oléfiniques vulcanisés (TPE-V), le poly(chlorure de vinyle), les polyuréthannes thermoplastiques (TPU), le poly(méthacrylate de méthyle) (PMMA), les polycarbonates (PC), le polystyrène (PS), l'acrylonitrile-butadiène-styrène (ABS), les mélanges polycarbonate/acrylonitrile-butadiène-styrène (PC/ABS) et le polypropylène (PP).

Parmi ces polymères thermoplastiques on utilisera de préférence les élastomères, en particulier les élastomères thermoplastiques styréniques (TPE-S), les élastomères oléfiniques vulcanisés (TPE-V) et le poly(chlorure de vinyle) plastifié (PVC).

Les TPE-S utilisables dans la présente invention comprennent principalement les familles suivantes :
- SBS (styrène-butadiène-styrène) : copolymères séquencés comportant un bloc central de polybutadiène encadré par deux blocs de polystyrène,
- SEBS : (styrène-éthylène-butadiène-styrène) : copolymères obtenus par hydrogénation des SBS,
- SEPS (styrène-éthylène-propylène-styrène) : copolymères comportant un bloc central poly(éthylène-propylène) flanqué de deux blocs de polystyrène,
- SEEPS (styrène-éthylène-éthylène-propylène-styrène) : copolymères obtenus par hydrogénation de copolymères styrène-butadiène/isoprène-styrène.

Ces polymères sont disponibles sur le marché en des qualités contenant des charges minérales, mais également sous forme de matériaux sans charges.

Dans la présente invention on utilisera des TPE essentiellement exempts de charges, ou contenant moins de 5 % de charges minérales, de préférence moins de 2 % de charges minérales.

Ils sont disponibles, par exemple, sous les dénominations commerciales suivantes : Dryflex (Hexpol TPE), Evoprene (AlphaGary), Sofprene (SOFTER), Laprene (SOFTER), Asaprene (Asahi Kasei), Nilflex (Taroplast).

Ces produits peuvent contenir une certaine fraction de plastifiants, fluidifiants ou lubrifiants organiques.

La température de fusion des TPE-S est avantageusement comprise entre 180 °C et 210 °C, en particulier entre 190 °C et 200 °C.

A l'état fondu ils doivent être suffisamment fluides pour pouvoir être moulés par injection. Il est toutefois impossible de donner des indications précises concernant leur viscosité à l'état fondu car celle-ci dépend non seulement de la température mais également de la force de cisaillement à laquelle les polymères sont soumis. Les fournisseurs proposent généralement des qualités dites « pour moulage par injection ».

Les élastomères oléfiniques vulcanisés (TPE-V, ou TPV d'après la norme ISO 18064) sont des mélanges d'un polymère thermoplastique, généralement du polypropylène (PP) et d'un caoutchouc, typiquement de l'EPDM, réticulé en cours de fabrication par extrusion. Du fait de cette vulcanisation en cours d'extrusion ces polymères sont également appelés « vulcanisats dynamiques » (*dynamic vulcanisates*). La phase caoutchouteuse est dispersée dans la matrice thermoplastique.

On peut citer à titre d'exemple de TPE-V disponibles commercialement le Sarlink® 4775B42 (Teknor Apex Co).

Les PVC plastifiés, ou PVC souples, contiennent des quantités élevées de plastifiants, typiquement entre 40 et 60% en poids. Leur point de fusion est compris entre 160 et 200°C.

On peut citer à titre d'exemple de PVC plastifiés utilisés avantageusement en tant que polymères d'encapsulation les produits suivants disponibles sur le marché :
BENVIC® (Solvay), TECHNIFAX® (Littleford Day), NAKAN® (Resinoplast), SUNPRENE® (Mitsubishi).

### Exemple

On fait passer des échantillons de vitrage en polycarbonate couvert d'un *hardcoat* à base de silicone (Basecoat Silfort SHP 470 + AS4700, Momentive) sous une torche à plasma Openair® (Plasmatreat) à buse rotative (22 mm de diamètre, angle de sortie 14°, inclinaison vers l'extérieur) d'une puissance de sortie de 500 voltampères.

La torche à plasma fonctionne avec de l'air filtré sous une pression comprise entre 3 et 4 bars. La torche à plasma est fixe et l'on fait défiler le bord des échantillons devant l'extrémité de la torche à une vitesse de 2 m/minute.

Le bord de chaque échantillon subit un seul passage sous la torche à plasma. Les distances entre la surface du vitrage et l'extrémité de la buse sont indiquées dans le tableau 1. L'axe de la torche est à la normale par rapport au plan du vitrage.

Après un simple passage de l'échantillon sous la torche à plasma, on mesure l'énergie de surface (mouillabilité) de la zone traitée conformément à la norme ISO 8296 avec une solution d'essai à base d'éthanol. Les valeurs obtenues sont indiquées dans le tableau 1.

On applique ensuite sur la zone traitée par plasma chacune des compositions de primaire ci-dessous :
IPDI + CPO-w : Isophorone-diisocyanate + polyoléfine chlorée dans de l'eau (LOCTITE TP661 (Henkel))
CPO-s : Polyoléfine chlorée dans un mélange xylène/éthylbenzène (KORATAC GM510 (Kômmerling))
CPO-w : Polyoléfine chlorée dans de l'eau (HARDLEN EW5515 (Toyobo))
IPDI-w : Isophorone-diisocyanate dans de l'eau (WITCOBOND 434-27 (Baxenden))
IPDI-s : Isophorone-diisocyanate dans un mélange acétate de n-butyle/acétate d'éthyle/butanone (SIKA 209N (Sika))
IPDI-MDI-s : Isophorone di-isocyanate et 4,4'-diphénylméthane-diisocyanate dans un mélange acétate d'éthyle/butanone (SIKA 209D (Sika))

L'application se fait au moyen de d'une mousse imprégnée de la composition de primaire.

On laisse le solvant s'évaporer à température ambiante, on introduit le bord des échantillons de vitrage dans un moule d'encapsulation et l'on surmoule soit avec un TPE-V (Sarlink® 4775B42, de Teknor Apex Co) soit avec un PVC plastifié (APEX® 1523F3, de Teknor Apex Co.)

Aucun préchauffage du vitrage n'est effectué entre l'étape de primage et l'encapsulation.

Après encapsulation, les échantillons sont stockés pendant 7 jours à 23 °C et 50 % d'humidité relative, puis sont soumis aux conditions de vieillissement accéléré suivantes : 14 jours à 70 °C à 95 % d'humidité relative, puis deux heures à -20 °C.

La qualité du contact adhésif est évaluée par un test de pelage à 90 ° (vitesse de traction 100 mm/min). On mesure la résistance au pelage en N/cm et le pourcentage de rupture adhésive ou cohésive conformément à la norme ASTM-D413.

Le Tableau 1 montre l'ensemble des résultats obtenus.

Les échantillons comparatifs sans traitement plasma ont simplement été nettoyés avec de l'isopropanol.

**Tableau 1**

| Résistance au pelage et type de rupture (cohésive ou adhésive) du contact adhésif en fonction de la distance entre buse et surface et de la composition de primaire utilisée | | | | | |
|---|---|---|---|---|---|
| Distance entre torche et surface du hardcoat (mm) | Energie de surface (mN/m) | Primage | Polymère d'encapsulation | Résistance au pelage après test de vieillissement accéléré (N/cm) | Type de rupture |
| 2 | > 60 | IPDI+CPO_{w} | TPE-V | >70 | 100 % RC* |
| 2 | > 60 | CPOₛ | TPE-V | >65 | 100 % RC |
| 2 | > 60 | CPO_{w} | TPE-V | >70 | 100 % RC |
| 2 | > 60 | IPDI_{w} | PVC | >50 | 45% RC/55% RA |
| 2 | > 60 | IPDIₛ | PVC | >75 | 100 RC |
| 2 | > 60 | IPDI+MDIₛ | PVC | >30 | 100 RA** |
| 4 | 54 | IPDI+CPO_{w} | TPE-V | >30 | 40% RC/60% RA |
| 4 | 54 | CPOₛ | TPE-V | >20 | 30% RC/70% RA |
| 4 | 54 | CPO_{w} | TPE-V | >30 | 40%RC/60% RA |
| 4 | 54 | IPDI_{w} | PVC | >10 | 100 % RA |
| 4 | 54 | IPDIₛ | PVC | >40 | 70% RC/30% RA |
| 4 | 54 | IPDI+MDIₛ | PVC | >10 | 100% RA |
| 8 | 36 | IPDI+CPO_{w} | TPE-V | 0 | 100% RA |
| 8 | 36 | CPOₛ | TPE-V | 0 | 100% RA |
| 8 | 36 | CPO_{w} | TPE-V | 0 | 100% RA |
| 8 | 36 | IPDI_{w} | PVC | 0 | 100% RA |
| 8 | 36 | IPDI_{S} | PVC | >20 | 100% RA |
| 8 | 36 | IPDI+MDIₛ | PVC | 0 | 100% RA |
| Sans plasma | < 30 | IPDI+CPO_{w} | TPE-V | 0 | 100% RA |
| Sans plasma | < 30 | CPOₛ | TPE-V | 0 | 100% RA |
| Sans plasma | < 30 | CPO_{w} | TPE-V | 0 | 100% RA |
| Sans plasma | < 30 | IPDI_{w} | PVC | 0 | 100% RA |
| Sans plasma | < 30 | IPDI_{S} | PVC | >10 | 100% RA |
| Sans plasma | < 30 | IPDI+MDIₛ | PVC | 0 | 100% RA |

| | | | | | |
|---|---|---|---|---|---|
| *RC = rupture cohésive **RA = rupture adhésive | | | | | |

On constate que dans les échantillons selon l'invention où la distance entre la buse et la surface du *hardcoat* est de 2 et 4 mm, toutes les valeurs de résistance au pelage sont supérieures à 10 mN/m.

Au contraire, pour les échantillons n'ayant subi aucun traitement plasma ou un traitement plasma avec une distance torche/substrat de 8 mm, la résistance au pelage est dans la très grande majorité des cas insuffisante.

On constate par ailleurs, que la résistance au pelage est plus élevée pour les échantillons traités à une distance de 2 mm que pour ceux traités à une distance de 4 mm.

L'énergie de surface des échantillons après traitement plasma est d'autant plus importante que la distance buse/surface est faible.

## Revendications

1. Procédé d'encapsulation d'un vitrage en polycarbonate comportant sur au moins une de ses faces un revêtement dur anti-abrasion à base de silicone, ledit procédé comprenant les étapes successives suivantes :
(a) le traitement d'une zone de la face du vitrage portant le revêtement dur à base de silicone par plasma atmosphérique avec une buse à plasma d'une puissance comprise entre 100 voltampères et 1000 voltampères, la distance entre l'extrémité de la buse à plasma et la surface du vitrage étant au plus égale à 7 mm,
(b) l'application sur ladite zone traitée par plasma atmosphérique d'une composition de primaire comprenant un ou plusieurs promoteurs d'adhésion choisis parmi les diisocyanates, polyisocyanates et polyoléfines chlorées, en solution ou suspension dans un solvant organique ou aqueux,
(c) l'évaporation du solvant de manière à former une couche de primaire sèche, et
(d) le surmoulage d'un polymère thermoplastique sur la zone couverte par la couche de primaire sèche.

2. Procédé selon la revendication 1, **caractérisé par le fait que** la vitesse de déplacement relatif de la buse plasma par rapport au vitrage est comprise entre 2 et 4 m/minute.

3. Procédé selon la revendication 1 ou 2, **caractérisé par le fait que** la distance entre l'extrémité de la buse de plasma et la surface du vitrage est inférieure à 6 mm, de préférence au plus égale à 5 mm, et en particulier comprise entre 2 mm et 4 mm.

4. Procédé selon l'une quelconque des revendications précédentes, **caractérisé par le fait que** la buse de plasma fonctionne avec une pression de gaz porteur, de préférence de l'air filtré, comprise entre 3 et 4 bars.

5. Procédé selon l'une quelconque des revendications précédentes, **caractérisé par le fait que** le ou les promoteurs d'adhésion sont choisis dans le groupe constitué de l'isophorone-diisocyanate (IPDI), du 4,4'-diphénylméthane-diisocyanate (MDI) et de polyoléfine chlorée greffée d'anhydride maléique.

6. Procédé selon la revendication précédente, **caractérisé par le fait que** la composition de primaire est constituée essentiellement d'un ou plusieurs promoteurs d'adhésion choisis parmi les diisocyanates, polyisocyanates et polyoléfines chlorées, en solution ou suspension dans un solvant organique ou aqueux.

7. Procédé selon l'une quelconque des revendications précédentes, **caractérisé par le fait que** le polymère thermoplastique est choisi parmi les élastomères thermoplastiques styréniques (TPE-S), les élastomères thermoplastiques oléfiniques vulcanisés (TPE-V) le poly(chlorure de vinyle), les polyuréthannes thermoplastiques (TPU), le poly(méthacrylate de méthyle) (PMMA), les polycarbonates (PC), le polystyrène (PS), l'acrylonitrile-butadiène-styrène (ABS), les mélanges polycarbonate/acrylonitrile-butadiène-styrène (PC/ABS) et le polypropylène (PP).

8. Procédé selon l'une quelconque des revendications précédentes, **caractérisé par le fait que** le polymère thermoplastique est un élastomère, de préférence un élastomère choisi parmi les élastomères thermoplastiques et le poly(chlorure de vinyle).

## Patentansprüche

1. Verfahren zum Einkapseln einer Polycarbonatverglasung, die auf mindestens einer ihrer Seiten eine harte Anti-Abriebs-Beschichtung auf Silikonbasis aufweist, wobei das Verfahren die folgenden aufeinanderfolgenden Schritte umfasst:
(a) das Behandeln einer die harte Beschichtung auf Silikonbasis tragenden Zone der Verglasungsseite durch atmosphärisches Plasma mit einer Plasmadüse mit einer Leistung zwischen 100 Voltampere und 1000 Voltampere, wobei der Abstand zwischen dem Endpunkt der Plasmadüse und der Oberfläche der Verglasung höchstens gleich 7 mm beträgt,
(b) das Aufbringen einer Primerzusammensetzung, die einen oder mehrere Haftvermittler, ausgewählt aus Diisocyanaten, Polyisocyanaten und chlorierten Polyolefinen in Lösung oder Suspension in einem organischen oder wässrigen Lösungsmittel umfasst, auf die mit atmosphärischem Plasma behandelte Zone,
(c) das Verdampfen des Lösungsmittels, sodass eine trockene Primerschicht ausgebildet wird, und
(d) das Aufformen eines thermoplastischen Polymers auf die von der trockenen Primerschicht bedeckte Zone.

2. Verfahren nach Anspruch 1, **dadurch gekennzeichnet, dass** die relative Verlagerungsgeschwindigkeit der Plasmadüse in Bezug auf die Verglasung zwischen 2 und 4 m/Minute beträgt.

3. Verfahren nach Anspruch 1 oder 2, **dadurch gekennzeichnet, dass** der Abstand zwischen dem Endpunkt der Plasmadüse und der Oberfläche der Verglasung weniger als 6 mm, vorzugsweise höchstens gleich 5 mm, und insbesondere zwischen 2 mm und 4 mm beträgt.

4. Verfahren nach einem der vorangegangenen Ansprüche, **dadurch gekennzeichnet, dass** die Plasmadüse mit einem Trägergasdruck, vorzugsweise gefilterter Luft, zwischen 3 und 4 bar arbeitet.

5. Verfahren nach einem der vorangegangenen Ansprüche, **dadurch gekennzeichnet, dass** der oder die Haftvermittler aus der Gruppe, bestehend aus Isophorondiisocyanat (IPDI), 4,4'-Diphenylmethandiisocyanat (MDI) und mit Maleinsäureanhydrid gepfropften chlorierten Polyolefinen, ausgewählt sind.

6. Verfahren nach vorangegangenem Anspruch, **dadurch gekennzeichnet, dass** die Primerzusammensetzung im Wesentlichen aus einem oder mehreren Haftvermittlern, ausgewählt aus Diisocyanaten, Polyisocyanaten und chlorierten Polyolefinen in Lösung oder Suspension in einem organischen oder wässrigen Lösungsmittel besteht.

7. Verfahren nach einem der vorangegangenen Ansprüche, **dadurch gekennzeichnet, dass** das thermoplastische Polymer aus den thermoplastischen Styrol-Elastomeren (TPE-S), den vulkanisierten olefinischen thermoplastischen Elastomeren (TPE-V) dem Polyvinylchlorid, den thermoplastischen Polyurethanen (TPU), dem Poly(methylmethacrylat) (PMMA), den Polycarbonaten (PC), dem Polystyrol (PS), dem Acrylnitril-Butadien-Styrol (ABS), den Polycarbonat/Acrylnitril-Butadien-Styrol-Mischungen (PC/ABS) und dem Polypropylen (PP) ausgewählt ist.

8. Verfahren nach einem der vorangegangenen Ansprüche, **dadurch gekennzeichnet, dass** das thermoplastische Polymer ein Elastomer, vorzugsweise ein Elastomer, ausgewählt aus den thermoplastischen Elastomeren und dem Polyvinylchlorid, ist.

## Claims

1. A process for encapsulating a polycarbonate glazing comprising, on at least one of its faces, a silicone-based abrasion-resistant hardcoat, said process comprising the following successive steps:
(a) the treatment of a region of the face of the glazing bearing the silicone-based hardcoat by atmospheric plasma with a plasma nozzle having a power of between 100 voltamperes and 1000 voltamperes, the distance between the end of the plasma nozzle and the surface of the glazing being at most equal to 7 mm,
(b) the application, to said region treated by atmospheric plasma, of a primer composition comprising one or more adhesion promoters selected from diisocyanates, polyisocyanates and chlorinated polyolefins, in solution or suspension in an organic or aqueous solvent,
(c) the evaporation of the solvent so as to form a dry primer layer, and
(d) the overmolding of a thermoplastic polymer over the region covered by the dry primer layer.

2. The process as claimed in claim 1, **characterized in that** the rate of relative movement of the plasma nozzle with respect to the glazing is between 2 and 4 m/minute.

3. The process as claimed in claim 1 or 2, **characterized in that** the distance between the end of the plasma nozzle and the surface of the glazing is less than 6 mm, preferably at most equal to 5 mm, and in particular between 2 mm and 4 mm.

4. The process as claimed in any one of the preceding claims, **characterized in that** the plasma nozzle operates with a carrier gas, preferably filtered air, pressure of between 3 and 4 bar.

5. The process as claimed in any one of the preceding claims, **characterized in that** the adhesion promoter(s) is (are) selected from the group consisting of isophorone diisocyanate (IPDI), 4,4'-diphenylmethane diisocyanate (MDI) and maleic anhydride-grafted chlorinated polyolefin.

6. The process as claimed in the preceding claim, **characterized in that** the primer composition essentially consists of one or more adhesion promoters selected from diisocyanates, polyisocyanates and chlorinated polyolefins, in solution or suspension in an organic or aqueous solvent.

7. The process as claimed in any one of the preceding claims, **characterized in that** the thermoplastic polymer is selected from styrenic thermoplastic elastomers (TPE-S), vulcanized olefinic thermoplastic elastomers (TPE-V), poly(vinyl chloride), thermoplastic polyurethanes (TPU), poly(methyl methacrylate) (PMMA), polycarbonates (PC), polystyrene (PS), acrylonitrile-butadiene-styrene (ABS), polycarbonate/acrylonitrile-butadiene-styrene (PC/ABS) blends and polypropylene (PP).

8. The process as claimed in any one of the preceding claims, **characterized in that** the thermoplastic polymer is an elastomer, preferably an elastomer selected from thermoplastic elastomers and poly(vinyl chloride).
